# EUROPEAN PATENT APPLICATION

(11) **EP 4 163 416 A1**
(43) Date of publication of application: **12.04.2023**
(21) Application number: 22200718.9
(22) Date of filing: 11.10.2022
(51) Int. Cl.: C23C 14/34, C23C 14/35, C23C 14/50, C23C 14/54, H01J 37/32, H01J 37/34

(54) **A VACUUM UNIT FOR PRODUCING MULTILAYER INTERFERENCE COATINGS ON AN OPTICAL ELEMENT**

(30) Priority: 11.10.2021 BY 20210277 U
(71) Applicant: Obshchestvo s organichennoy otvetstvennostyu «IZOVAK», 220075 Minsk (BY)
(72) Inventor: KHAKHLOU, Yauhen, 220088 ul. Pulihova, d. 45, kv. 128, Minsk (BY); MYSLIVETS, Aleksandr Sergeevich, 222211 Novodvorie, d. 15, Smolevichsky r-on, Minskaja obl. (BY); HSING-LUNG, LIN, New Taipei City 239 (TW)
(74) Representative: Lapienis, Juozas

(57) **Abstract**

The technical solution refers to vacuum technology, in particular to vacuum units for depositing thin film multilayer interference coatings and is aimed at solving the problem of providing a commercial-scale unit for producing high-precision optical products.

Set problem is solved by using planar magnetrons mounted on autonomous motion devices in a vacuum unit, with a variable distance from the center of the working surfaces of the targets to the axis of rotation of the optical element holder and from the working surface of the targets to the front surface of the optical element clamped in the holder. The control signal for changing mentioned distances is generated by the optical control system according to the optical signal values provided by optical properties of the deposited coating at different points of the front surface of the optical element and obtained from two geometrically spaced optical channels.

The vacuum unit makes it possible to reduce the duration of the technological process while increasing the uniformity of the produced thin-film layers, thereby increasing the efficiency of equipment use and increasing the yield of valid high-precision optical products.

## Description

The technical solution as claimed relates to vacuum technology, in particular to vacuum units for depositing thin film multilayer optical coatings. The unit can be used for commercial-scale production of narrowband interference filters used in astrophysical research to obtain monochromatic images of space objects, in fiber-optic communication networks based on multi-channel serial data transmission, for the production of optical systems, such as highly reflective mirrors, beam splitters with a steep front, other products comprising a multilayer thin film coating with hundred or more layers assembled together.

A vacuum unit [1] for producing multilayer interference coatings on an optical element with an ion source directed to the surface of a replaceable flat rectangular target is known. The ion source and the target are fixed relative to each other on a movement device for their simultaneous movement in a direction perpendicular to the long profile of the source. To improve the uniformity of a coating, the optical element is mounted in a rotatable holder. Also, to improve the quality of the produced coating, the unit uses a second assisting ion source directed at the optical element. It is used to smooth the surface of the optical element and suppress the formation of additional roughness with an increase in the number of films and coating thickness. It can also be used to oxidize the deposited material.

The main disadvantage of this kind of vacuum units is the used coating deposition technique, that does not ensure high deposition rates, which does not ensure high speeds of producing them. Therefore, the process of depositing multilayer coatings with hundred or more layers in a single vacuum cycle can take several days, which makes it difficult to use the described vacuum unit on an industrial scale. Furthermore, the disadvantages of the ion-beam method for depositing coatings related to the heterogeneity of a multilayer coating are due to non-uniform extraction of the ion beam from the ion source and non-uniform sputtering of the target material.

Magnetron spattering devices or magnetrons can be also used to produce optical elements with complex multilayer coatings. Magnetrons also belong to ion sputtering devices and their distinctive feature is high sputtering rate due to strong transverse magnetic field, which causes plasma localization near the sputtering (working) target surface and by this way increases the ion current density. The use of magnetrons significantly speeds up the manufacturing of optical products with a coating that includes a large number of thin-film layers and, consequently, increases the yield of the final products. But in the field of magnetron sputtering, there is a need to reduce the non-uniformity of erosion of the target on its sputtering surface. This needs to be considered not only to use the targets effectively, but also as a factor that negatively affects the quality of thin films deposited onto the optical element.

One of the reasons for the non-uniform erosion of the target working surface is an increase in erosion in the areas where the magnetic field lines are parallel to the sputtering surface. There are known technical solutions in which matrices of magnets located behind the target are rotatable relative to the target, or the sputtered targets themselves are movable relative to the magnets for more uniform erosion of its working surface.

The patent document [2] describes a vacuum unit having a planar magnetron including a movable flat target. The vacuum unit includes a vacuum process chamber with a holder for securing the optical element inside the chamber and for its rotation around its central axis coinciding with the axis of rotation of the holder. A modified magnetron installed inside the vacuum process chamber was used as a coating device. The magnetron includes a flat target, the working surface of which is partially covered by a shielding device, and a system of magnets. The target is mounted on a movable support such that it is movable relative to the magnets, and the system of magnets located behind the target is immovable relative to the process chamber, while the magnetrons themselves are fixed on nonmoving mounting surfaces. Thus, the described vacuum unit uses a magnetron with a movable target that slides along the magnetic system to form a homogeneous erosion profile on its working surface and, additionally, rotates to maintain a stationary deposition cloud.

The moving erosion zone of the target's working surface is both an advantage and a disadvantage of the described technical solution at the same time, since it can cause non uniform coating and decrease precision of thin films deposition. Furthermore, using moving targets it becomes problematic to cover the target areas that are not subject to erosion with the shielding device. Dielectric films layers of unwanted material produced by back-scattered coating material or chemically active gases, are formed on the exposed areas of the target working surface that are not involved in the sputtering process. But the described technical solution does not contain instructions on how to increase the resistance of the magnetron to the formation of a dielectric film on the target surface, which is necessary to achieve high quality and stable reproducibility of the optical properties of deposited coatings.

There are known vacuum units, which design allows to reduce the possible technical effects on the quality of the deposited coatings. For example, the patent document [3] describes a vacuum unit for production of multilayer coatings having a rigid frame. The design of the described vacuum unit is the closest to the claimed technical solution. The frame is used for mounting technological and other devices involved in the technological process of coatings manufacturing. It is installed and designed to reduce the effects of vibrations and bends of the process chamber during the technological process. Such fluctuations can be caused by the operation of various devices involved in the vacuum technological process, such as vacuum pumps, or by environmental vibrations. The frame can be designed as an element standing separately from the vacuum process chamber, or as a unit mounted on one of its stationary surfaces, or it can be designed in another efficient manner that allows to frame to be isolated from the above-mentioned vibrations and bends. The major function of the frame is to hold the devices mounted thereon in a stable position relative to each other during the technological process.

In addition to the vacuum process chamber and the frame, the unit described in the patent document [3] includes: optical element holder; optical element with open front surface to be coated; planar magnetrons; sputtering targets with working surfaces parallel to and directed towards the front surface of the optical element. The design of the vacuum unit comprises special motion devices on which magnetrons are fixed and that allow to control the distance from the working surface of the target to the front surface of the optical element. In addition to devices, that monitor various process parameters, the described unit includes a device for continuous monitoring of each coating layer thickness. During optical coatings deposition, the thickness of the each layer must be strictly controlled and be the same on the entire front surface of the optical element. The thin films optical thicknesses determine the properties of the final optical coating, such as reflectivity, transmittance and maximum transmission wavelength, and is a more accurate characteristic than the geometric thickness of the film. Therefore, there is so-called method of end-to-end control of the optical thickness, which widely used to monitor the layers optical thicknesses and takes into account the change in the optical properties of a thin film during deposition on the optical element. The described vacuum unit is equipped with an optical control system to perform the end-to-end control of optical thickness in the center and at certain distance from the center of the optical element.

Described above vacuum unit can't provide the demanded yield of required products after each vacuum cycle of multilayer interference coating manufacturing. Most of the coated optical element does not have the necessary optical properties: coating corresponds to the specified requirements just in a narrow ring on the front surface of the optical element. The coating that meets the specified requirements is placed in a narrow ring on the front surface of the optical element. To increase the yield of suitable product, the area of the ring must be increased. So, depositing a coating it is necessary to control not only the distance from the front surface of the optical element to the working surface of the target, as it is provided in the unit according to the patent document [3], but also the distance from the rotation axis of the optical element to the center of the target.

The present technical solution is directed to solving the technical problem of inventing industrial-scale vacuum unit for producing multilayer interference coatings suitable for the manufacture of high-precision optical products. Meanwhile, the vacuum unit should ensure an increase in the yield of useful products due to high reproducibility of the optical parameters of multilayer coatings, as well as the quality and uniformity of individual layers.

The stated goal in the claimed technical solution is achieved by mounting the magnetrons on autonomous motion devices with the possibility of changing the distance Y from the center of the target working surfaces to the holder rotation axis. Specifically, the distance Y is variable in the range of 200-400 mm, and the distance X from the working surfaces of the targets to the front surface of the fixed optical element is 150-450 mm.

The claimed vacuum unit contains a rigid frame; holder for an optical element, which is rotatable around and movable along its central axis, coinciding with the central axis of the optical element fixed in the holder; at least two magnetrons with targets, whose working surfaces are parallel to the plane of the front surface of the optical element; a device for shielding the working surfaces of the targets; two-channel optical control system for measuring optical properties of the coating in two geometrically spaced areas of optical element during deposition; at least one plasma source and an optical element heating device.

Preferably, the plasma source is installed in a process chamber with the possibility of affecting the working surface of the targets and the front surface of the optical element.

In a possible design, the vacuum unit contains four magnetrons mounted on a frame comprising two spaced parallel planes connected by stiffeners. An optical element holder and heater are also mounted on the frame.

One example of magnetron targets shielding device includes at least one shield, mounted on a movement mechanism.

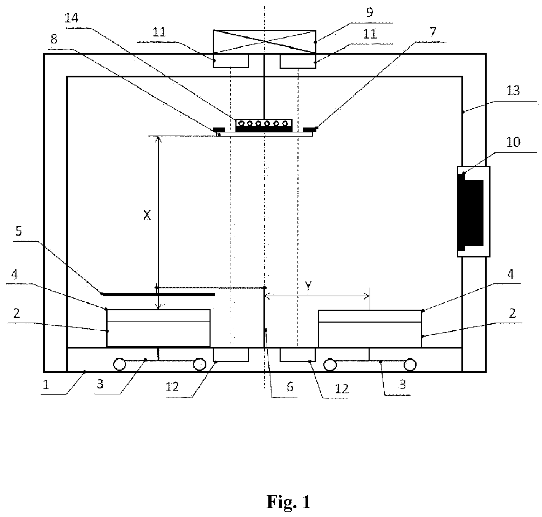

The essence of the claimed technical solution is explained by a representation in FIG. 1., that schematically shows a vacuum unit for multilayer interference coatings manufacturing on an optical element.

The vacuum unit includes a process chamber 1 with at least two planar magnetron sputtering devices 2 (hereinafter referred to as magnetrons) inside with installed targets 4 , whose working surfaces are subjected to sputtering process. Magnetrons 2 participate in the process in turn, since they have targets 4 of different materials and each magnetron 2 deposits thin-film layers of a certain composition, providing the manufacturing process of a multilayer interference thin-film coating on the optical element 8.

A device for shielding the working surfaces of the targets 4 is also mounted inside the process chamber 1. In a possible design version, the shielding device consists of a movement mechanism 6 with at least one attached shield 5, what ensures the movement of the shield 5 over the working surfaces of the targets 4. Thus, during the technological process, the shield 5 covers the working surface of one of the targets 4 allowing to turn on and stabilize the magnetron under the shield 5 and shielding the surface of the target 4 from coating deposition during the operation of the another magnetron 2.

If more than two magnetrons 2 are installed in the process chamber 1, the shield 5 can be designed to provide simultaneous covering for targets working surfaces 4 of multiple magnetrons 2.

Also, there may exist several shields 5 on one or more movement mechanisms 6 for each magnetron individually. The movement mechanism 6 may be adapted to use various principles of moving the shield 5, such as rotation, shear, reciprocating motion, etc.

The thickness uniformity of each thin-film layer on the optical element 8 changes during deposition process due to erosion and the changing geometry of the targets working surfaces 4, caused by consumption of the target material.

To improve the layers uniformity in the manufactured coating, each magnetron 2 is mounted on a motion device 3. It allows to move the magnetron, maintaining the plane of the targets working surface 4, and/or to change the inclination angle of the target 4 of the magnetron 2 towards the plane of the front surface of the optical element 8. Each of the magnetrons 2 is equipped with autonomous motion device 3. This means that for a vacuum unit with two magnetrons 2, both before and during the operation each of the magnetrons 2 can be moved by its motion device 3 to a needed position.

If more than two magnetrons 2 are installed in the process chamber 1, these technological devices can work either in turn or in pairs. If the number of installed magnetrons 2 is even, pairs of simultaneously operating magnetrons form a magnetron sputtering system. Since each magnetron 2 from the magnetron sputtering system has its own autonomous displacement device 3, it can be displaced by a distance that does not coincide with the displacement distance of another magnetron from the magnetron spattering system.

In order to ensure high efficiency of the deposition process and improve films quality, at least one induction-coupled plasma generation device 10 (hereinafter referred to as the plasma source) directed into the sputtering zone is used in the patented vacuum installation. Since the plasma source 10 can perform various functions during the coating deposition, preferably it is installed to affect the working surface of the targets 4 and the front surface of the optical element 8. In this case, the plasma source 10 can be used to preclean the front surface of the optical element 8 immediately before the coating process as well as to assist the technological process, since it can speed up the technological process and improve the coating quality due to the ability to control the ion density in the sputtering zone. Plasma beam generated by a plasma source 10 and injected into the sputtering zone, or rather into the magnetron discharge plasma zone, allows increasing the resistance to the dielectric film formation on the working surface of the target 4. Consequently, it allows to significantly increase the coating deposition rate and reduce the effect of arcing on the target surface 4, thereby increasing the quality of thin films deposited on the optical element 8. The use of a plasma source 10 reduces the time of the technological cycle by minimizing the formation of contaminants and chemical reaction products on the working surface of the targets 4, thereby improving the functional characteristics of magnetrons 2 by expanding the area of existence of a magnetron discharge plasma, and contributes to achieving high quality of the deposited coatings and stable repeatability of their physical properties.

If process chamber 1 comprises two magnetrons 2 and one plasma source 10, when the magnetrons 2 are alternating during technological process the plasma source 10 works either constantly, switching to different operating modes, or it is switched on together with only one of the magnetrons 2. If more than two magnetrons 2 are installed in the process chamber 1, several plasma sources 10 may be used. In this case, each of the plasma sources may perform optical element 8 front surface processing before the start of the deposition process, and/or turns on together with the start of operation of one of the magnetrons 2 or magnetron sputtering system and assisting deposition, and/or works continuously.

The holder 7 inside the vacuum process chamber 1 is to fix the optical element 8 with the front surface parallel to the plane of the working surfaces of the targets 4. The optical element 8 is fixed in the holder 7 in such a way that the central axis of the holder 7 coincides with the central axis of the optical element 8. The holder 7 of the optical element 8 is designed to rotate around and move along its central axis.

Since the azimuthal uniformity of the manufactured thin-film coating depends on the rotation speed of the optical element 8 during the coating manufacturing process, patented vacuum unit comprises the rotation device 9, which provides rotation speed of the optical element 8 up to 3000 revolutions per minute.

In order to avoid contamination of the sputtering zone, all the mechanisms of the vacuum unit are removed from the sputtering zone. Thus, the rotation device 9 of the holder 7 is located either inside the process chamber 1 outside the sputtering zone, or outside the process chamber 1 itself, as shown in FIG. 1. For the same reason, motion devices 3 of the magnetrons 2 and the movement mechanism 6 of the screen 5 are also outside sputtering zone of vacuum unit. To reduce contamination, it is possible to use more suitable mechanisms in the mentioned devices, for example, a magnetic coupling in the rotation device 9.

Specific positions of magnetrons 2 and holder 7 in the sputtering zone, indicated in FIG. 1 as X and Y, are maintained to achieve specified uniformity of the deposited thin-film coating.

The distance X is the distance from the front surface of the optical element 8 to the working surface of the target 4 (the front surface of the optical element is the surface facing the sputtering zone, undergoing coating).

The distance Y is the distance from the central rotation axis of the optical element 8 to the center of the target 4.

The distances X and Y were determined experimentally in the ranges of X=150-450 mm, Y=200-400 mm. The distances X and Y in these ranges allow to set up a vacuum unit to achieve ultra-high accuracy in the uniformity of the multilayer interference coatings deposition.

If the optical element 8 in the holder 7 should not move along the holder central axis inside the vacuum process chamber 1 during the technological process, the distance X may be fixed throughout the entire technological process and can be changed during the interoperative period or readjustment of the vacuum unit . In this case, during the coating deposition process the optical element 8 rotates with the holder 7 by rotation device 9 around its central axis and the spatial position of the optical element 8 in the deposition zone remains unchanged.

The distance Y calculated before the start of the technological process for each magnetron 2 and can change repeatedly during the process depending on the required uniformity, but is maintained in the above interval.

Possibility to achieve calculated optical properties of deposited coatings depends on used control method. For optical thin films, their optical thickness determines the optical properties of the coating itself and is an accurate characteristic. The patented vacuum unit is equipped with an automatic system for end-to-end control of the optical thickness of the coating, which has two optical channels. The existence of two optical channels is ensured by the presence of two emitters 11 and two receivers 12 in the optical control system. The method of optical thickness control is monochromatic photometry. This method is based on recording of the transmission maxima and minima arising from interference phenomena and caused by changing of optical film thickness.

End-to-end control of the optical thickness is carried out during the coating deposition in two points of the optical element 8 at different radii from the rotation axis: in the zones of the greatest uniformity of the manufactured coating.

The difference in the coating optical thickness in these two points is determined according to the difference of signals coming through two optical control channels.

The optical control software compares the values obtained from two optical channels, makes calculation according to the value of the signal difference and sends an appropriate signal to control the deposition process. It is a signal to change specified parameter of the technological equipment, for example, the position of magnetrons 2.

For heating and thermal stabilization of the optical element 8, at least one heater 14 oriented towards the optical element 8 is installed in the vacuum process chamber 1. The location of the heater in the vacuum process chamber can be different: above or below the optical element 8, on the holder 7, etc.

For the purposes of mounting technological devices, motors and other components of the vacuum technological process in the vacuum process chamber 1, a special rigid frame 13 can be used. The frame is used to minimize the impact of vibrations and bends that technological chamber experiences during the technological process. For this purpose, the frame 13 can be completely isolated from the process chamber 1 or mounted on one of its stationary surfaces, for example, on the base. The frame 13 consists of two flat horizontal surfaces connected by vertical stiffeners. Magnetrons 2 and a screen 5 can be mounted on one of the lower surfaces, on the side of the magnetron discharge plasma generation area. Holder 7 with an optical element 8 can be fixed on the upper plane of the frame 13. In this case, the motion devices 3 of the magnetrons 2, the movement mechanism 6 of the screen 5, the rotation device 9 of the holder 7 are mounted outside the frame 13. With this arrangement of the devices, the sputtering zone is preserved from contamination by the mechanical parts of the listed devices. Furthermore, the orientation of the components relative to each other and the distances between them remain stable, i.e. X and Y parameters are reliably and precisely regulated.

Claimed vacuum unit includes four planar magnetrons 2, working in pairs and mounted on a frame 13, equipped with round targets 4 with a diameter of 250 mm; two sources of inductive-coupled plasma 10, installed with the possibility of simultaneous treatment of the working surface of the targets 4 and the front surface of the optical element 8 and a flat holder 7, mounted on the frame 13. This vacuum unit operates as follows. A nine-inch flat optical element 8 made of optical glass is clamped in the holder 7, which purpose is to hold one optical element 8 inside the process chamber 1 in the deposition zone at an calculated height X above the working surface of the targets 4. The central axis of the clamped optical element 8 coincides with the central axis of the holder 7, and its front surface is parallel to the working surface of the flat targets 4 of magnetrons 2.

Using low-vacuum and high-vacuum pumping systems (not shown in the figure), the vacuum process chamber 1 is pumped out reaching the appropriate initial pressure to start the technological process. During the pumping or after reaching appropriate initial pressure, the heater 14 located above the optical element 8 on the holder 7, is turned on and heats the optical element 8 to a needed temperature. Then the plasma source 10 mounted on the wall of the vacuum process chamber 1, above the magnetrons 2 of the first spray system, is switched on and started operation. The plasma source 10 performs precleaning of the front surface of the optical element 8 before the coating process. During the cleaning operation, the rotation device 9 of the holder 7 rotates the optical element 8 at a speed of 400-2000 revolutions per minute, and the working surface of the targets 4 of the first magnetron sputtering system is covered with a screen 5. Then first magnetron sputtering system turn on being under the screen 5 and performs pre-sputtering to release the working surfaces of the targets 4 from the oxide film. After completing the preparatory procedures, the vacuum unit is ready for the coating deposition process.

Deposition of the first thin-film layer of a multilayer interference coating on the front surface of the optical element 8 occurs when both magnetrons 2 from the first magnetron sputtering system are operating, and the plasma source 10 process the working surface of their targets. To start the technological process, the working surface of the targets 4 of the working magnetron sputtering system is opened by shifting the screen 5 using the movement mechanism 6. In accordance with the technological recipe, working gases and electricity of a certain values and frequency are supplied to the process chamber 1, to the magnetrons 2 and to the plasma source 10.

Simultaneously with the start of the first thin-film layer deposition, the second magnetron sputtering system is switched on being covered by a screen 5 displaced by the movement mechanism 6, performing pre sputtering, thus preparing their targets working surfaces for the technological process.

Deposition of the first thin-film layer by the first magnetron sputtering system stops after getting the corresponding signal from the optical control system, that monitors optical thickness of the growing thin-film layer. The optical control system, using emitters 11 and receivers 12, monitors the optical thickness of the deposited coating through two optical channels in two points on the optical element 8. Then, the system compares the values obtained through two optical channels with each other. The result of comparing the magnitudes of optical signals is used as a feedback signal to generate the corresponding control signal for motion devices 3 to change the distance Y of working magnetrons 2. Since the monitoring of the thin-film layers optical parameters through both optical channels occurs during the entire deposition technological cycle, so their matching also occurs throughout the entire technological cycle. At the same time, since each of the magnetrons 2 is installed on a separate motion device 6, the parameter Y is calculated and changed autonomously for each magnetron 2.

The next thin-film coating layer is deposited in the same way using a second magnetron sputtering system in cooperation with a previously unused plasma source until receiving a command from the optical control system about its finish. Alternating the operation of magnetron sputtering systems with different targets 4 materials and using different plasma sources 10, a multilayer interference coating with two types of alternating thin-film layers with specified characteristics is manufactured.

High uniformity of the deposited thin-film layers is achieved by maintaining the specified distances X and Y. In the vacuum unit uniformity is also provided by the use of an optical control system with two optical channels. Measured optical parameters of the manufactured coating are received through optical channels by the optical control system and compared with each other. If the obtained comparative values of optical signals do not meet the permissible discrepancies, the magnetrons are automatically moved within the distance Y in the installation to match the measured optical characteristics.

The quality of the manufactured coatings and the deposition rate in the patented vacuum unit are also affected by the plasma sources, which inject charged particles into the magnetron discharge plasma zone, affecting the plasma and the target. As a result, it becomes possible to reduce the working pressure of the technological process, and by this way to increase the free path distance of atomized materia and to improve the quality of optical coatings. Also, operation of plasma sources increases the density of ionized states in plasma, and in this case the sputtering process is becoming supported by ions from two independent sources - its own magnetron discharge and an external plasma beam.

Since the vacuum unit uses technological devices for high-speed sputtering, i.e. combination of magnetrons and assisting plasma sources, the coating cycle time is going to be reduced due to the reduction of the technological process time. Compared with vacuum units using ion beam sputtering technique, the magnetron one has not only higher productivity, i.e. the multilayer coating deposition rates, but also a longer period of operation without maintenance. Accordingly, vacuum units equipped with magnetrons have a higher utilization rate, i.e. increased operation efficiency. At the same time, the targets in magnetron sputtering devices can be used till the maximal targets erosion by installing magnetrons on motion devices.

Consequently, for the claimed vacuum unit of the described design it possible to solve the mentioned technical tasks, ensure a reduction in the technological process time and improve the uniformity of the deposited thin-film layers, thereby increasing the efficiency of the vacuum equipment and increasing the yield of valid high-precision optical products.

### Sources of information:

1. Patent RU2654991, publ. 23.05.2018.
2. Patent US9771647, publ. 26.09.2017.
3. Patent US6736943, publ. 18.05.2004.

## Claims

1. A vacuum unit for producing multilayer interference coatings on an optical element including a process chamber with a rigid frame inside, a holder for an optical element, which is rotatable around and movable along its central axis coinciding with the central axis of the fixed optical element, which front surface is undergoing multilayer coating deposition in the process chamber, at least two magnetrons with targets, whose working surface planes are parallel to the plane of the front surface of the fixed optical element, and the distance X from the working surfaces of the targets to the front surface of the fixed optical element is maintained within 150-450 mm, while the magnetrons are mounted on autonomous motion devices with the possibility of changing the distance Y from the center of the targets working surfaces to the holder rotation axis and the distance Y is limited to an interval of 200-400 mm; a device for shielding the working surfaces of the targets, an optical control system having two geometrically spaced optical channels capable of measuring the optical properties of the formed coating at different points of the front surface of the optical element, at least one plasma source and a heater for optical element.

2. The vacuum unit according to claim 1, wherein it comprises four magnetrons.

3. The vacuum unit according to claim 1, wherein the frame has two spaced parallel flat surfaces connected by stiffening ribs.

4. The vacuum unit according to claim 1, wherein the magnetrons and the holder are mounted on the frame.

5. The vacuum unit according to claim 1, wherein the plasma source is installed such that it affects the working surface of the targets and the front surface of the optical element.

6. The vacuum unit according to claim 1, wherein the device for shielding consists of a movement mechanism with at least one shield mounted thereon.

7. The vacuum unit according to claim 1, wherein the optical element heater is mounted on the holder.
